Europäisches Patentamt

European Patent Office

Office européen des brevets

(11) Veröffentlichungsnummer: **0 245 826**

**A 1**

(12) **EUROPÄISCHE PATENTANMELDUNG**

(21) Anmeldenummer: **87106823.5**

(22) Anmeldetag: **11.05.87**

(51) Int. Cl.⁴: **H01L 29/743** , H01L 29/06

(30) Priorität: **13.05.86 DE 3616002**

(43) Veröffentlichungstag der Anmeldung:
**19.11.87 Patentblatt 87/47**

(84) Benannte Vertragsstaaten:
**DE FR GB SE**

(71) Anmelder: **Siemens Aktiengesellschaft Berlin
und München**
**Wittelsbacherplatz 2**
**D-8000 München 2(DE)**

(72) Erfinder: **Bechteler, Martin, Dr. Ing.**
**Nelkenweg 10**
**D-8011 Kirchheim(DE)**

(54) **Halbleiterbauelement mit asymmetrisch sperrendem Thyristor und in Reihe geschalteter Diode.**

(57) Die Reihenschaltung aus einem asymmetrisch sperrenden Thyristor (1) und einer Diode (2) hat gegenüber einem symmetrisch sperrenden Thyristor bei insgesamt gleicher Sperrspannung den Vorteil einer geringeren Speicherladung. Die Reihenschaltung ist durch mechanische und elektrische Verbindung der Halbleiterkörper der beiden Bauelemente gebildet. Zur Erhöhung der Oberflächen-Durchbruchsspannung werden die Ränder (15, 16) der beiden Halbleiterkörper derart abgeschrägt, daß ihre Randflächen kontinuierlich ineinander übergehen.

## FIG 1

EP 0 245 826 A1

# Halbleiterbauelement mit asymmetrisch sperrendem Thyristor und in Reihe geschalteter Dioden

Die Erfindung bezieht sich auf ein Halbleiterbauelement mit einem asymmetrisch sperrenden Thyristor und einer dem Thyristor in Reihe geschalteten Diode, deren Halbleiterkörper elektrisch und mechanisch mit dem Anodenkontakt des Halbleiterkörpers des Thyristors verbunden ist, so daß eine einzige Scheibe gebildet wird, und mit einer Abschrägung der Randflächen jedes Halbleiterkörpers.

Ein Halbleiterbauelement dieser Art ist beispielsweise in der DE-OS 34 25 719 beschrieben worden. Unter einem asymmetrisch sperrenden Thyristor versteht man einen Thyristor, der im wesentlichen nur in einer Richtung Sperrspannung aufnehmen kann. In der anderen Richtung kann er lediglich eine Spannung von einigen 10 V sperren. Dies rührt daher, daß zwischen der Mittelzone und der Anodenzone eine stark dotierte Zwischenschicht des gleichen Leitungstyps wie die Mittelzone angeordnet ist. Ein solcher asymmetrisch sperrender Thyristor hat aber gegenüber einem symmetrisch sperrenden Thyristor den Vorzug, daß er bezogen auf die gleiche Sperrspannung etwa nur die halbe Mittelzonendicke benötigt

Damit der asymmetrisch sperrende Thyristor auch in Rückwärtsrichtung Spannung aufnehmen kann, ist ihm eine Leistungsdiode in Reihe geschaltet. Eine Leistungsdiode sperrt ebenfalls nur in einer Richtung und hat, bezogen auf einen symmetrischen Thyristor gleicher Sperrspannung, ebenfalls eine Mittelzone von nur etwa der halben Dicke.

Ein aus einem asymmetrisch sperrenden Thyristor und einer Diode zusammengesetztes Halbleiterbauelement hat den Vorzug, daß die Speicherladung gegenüber einem symmetrisch sperrenden Thyristor gleicher Sperrspannung drastisch reduziert ist. Dies rührt daher, daß die Speicherladung im wesentlichen dem Quadrat der Dicke der Mittelzone proportional ist. Beim zusammengesetzten Halbleiterbauelement der erwähnten Art wird daher eine Speicherladung zu erwarten sein, die nahe an der Hälfte der Speicherladung eines symmetrisch sperrenden Thyristors liegt.

Zur Erhöhung der Oberflächen-Durchbruchsspannung eines Halbleiterbauelements ist es bekannt, die Randflächen der Halbleiterbauelemente abzuschrägen. Beim beschriebenen Halbleiterbauelement sind die Randflächen der Halbleiterkörper von asymmetrischem Thyristor und Diode jeweils für sich abgeschrägt und dann mechanisch und elektrisch miteinander verbunden. Dies ist jedoch relativ umständlich. Außerdem entstehen Stufen in der Randkontur, die sich ungünstig hinsichtlich der elektrischen Eigenschaften und bei der Montage auswirken können.

Der Erfindung liegt daher die Aufgabe zugrunde, ein Halbleiterbauelement der beschriebenen Gattung so weiterzubilden, daß diese Nachteile vermieden werden.

Diese Aufgabe wird dadurch gelöst, daß die Randflächen beider Halbleiterkörper kontinuierlich ineinander übergehen.

Weiterbildungen der Erfindung sind Gegenstand der Unteransprüche.

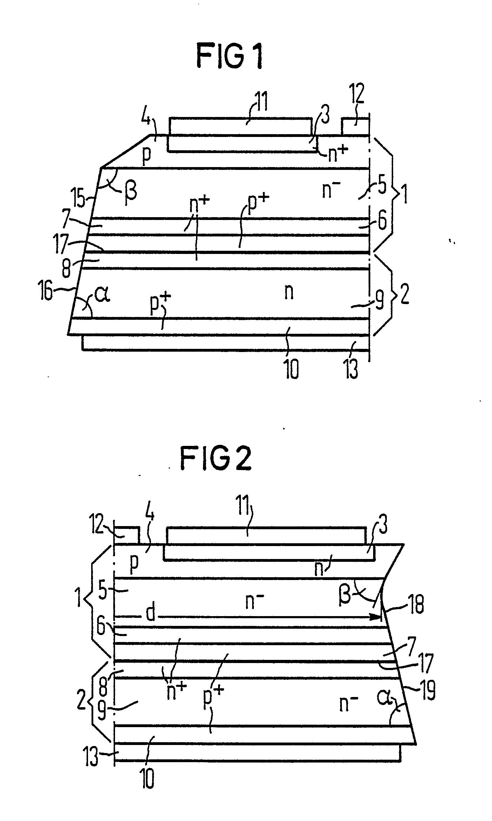

Die Erfindung wird anhand einiger Ausführungsbeispiele in Verbindung mit den Fig. 1 bis 7 näher erläutert. Diese Figuren zeigen Schnitte durch je ein Teil einer aus den beiden Halbleiterkörpern zusammengesetzten Scheibe in verschiedenen Ausführungsformen.

Das erste Ausführungsbeispiel nach Fig. 1 zeigt eine Scheibe, die aus dem Halbleiterkörper 1 eines asymmetrisch sperrenden Thyristors und einem Halbleiterkörper 2 einer Leistungsdiode zusammengesetzt ist. Der Halbleiterkörper 1 weist von oben nach unten, d. h. von der Katoden-zur Anodenseite eine Emitterzone 3, eine katodenseitige Basiszone 4, eine Mittelzone 5, eine stark dotierte Zwischenzone 6 und eine anodenseitige Emitterzone 7 auf. Die Leitfähigkeit dieser Zonen ist $n^+pn^-n^+p^+$. Der Halbleiterkörper 2 der Leistungsdiode hat eine Katodenzone 8, eine Mittelzone 9 und eine Anodenzone 10. Die Dotierungsfolge ist $n^+np^+$. Die Emitterzone 3 ist mit einer Emitterelektrode 11, die Basiszone 4 ist mit einer Gateelektrode 12 und die Anodenzone 10 ist mit einer Anodenelektrode 13 versehen. Die Halbleiterkörper 1 und 2 sind beispielsweise durch eine Legierungsschicht 17 miteinander verbunden.

Die Halbleiterkörper 1 und 2 haben Randflächen 15 bzw. 16. Diese Randflächen sind derart abgeschrägt, daß die Randfläche 15 mit dem pn-Übergang zwischen den Zonen 4 und 5 einen sogenannten negativen Winkel $\beta$ und die Randfläche 16 mit dem pn-Übergang zwischen den Zonen 9 und 10 einen sogenannten positiven Winkel $\alpha$ einschließt. Positiv wird der Winkel dann genannt, wenn sich die Querschnittsfläche von der höher dotierten Zone zur niedriger dotierten Zone verjüngt; negativ wird der Winkel dann genannt, wenn sich die Querschnittsfläche des Halbleiterkörpers von der höher dotierten Zone zur niedriger dotierten Zone erweitert. Der positive Winkel $\alpha$ erhöht in bekannter Weise die Oberflächen-Durchbruchsspannung, während die an sich negative Wirkung des negativen Winkels $\beta$ dadurch kom-

pensiert wird, daß die Randfläche in bekannter Weise unter einem kleinen Winkel von z. B. 4 bis 10° abgeschrägt wird. Der negative Winkel β hat herstellungstechnische Gründe, da die Randflächen der Halbleiterbauelemente entweder auf einer Ätzschleuder, durch Läppen oder Sandstrahlen abgeschrägt werden.

Die Randflächen 15 und 16 gehen hier kontinuierlich ineinander über; sie bilden gemeinsam einen Kegelstumpf. Damit kann der Rand der Scheibe auf einfache Weise mit nur zwei Arbeitsgängen abgeschrägt werden, indem zunächst die Scheibe aus den Halbleiterkörpern 1 und 2 zusammengesetzt und dann die gemeinsame Randbehandlung vorgenommen wird.

Das Ausführungsbeispiel nach Fig. 2 unterscheidet sich von dem nach Fig. 1 dadurch, daß die Randfläche des asymmetrisch sperrenden Thyristors mit dem pn-Übergang zwischen den Zonen 4 und 5 einen positiven Winkel β wenigstens dort einschließt, wo der Schnittpunkt zwischen Randfläche und dem pn-Übergang liegt. Der Winkel α zwischen den Zonen 9 und 10 ist wie im Ausführungsbeispiel nach Fig. 1 positiv. Eine solche Randkontur kann beispielsweise durch Ätzen oder Sandstrahlen erzeugt werden. Damit entstehen Randflächen 18, 19 an den Halbleiterkörpern 1 bzw. 2, die wiederum kontinuierlich ineinander übergehen. Die Halbleiterscheibe wird wiederum vor der Randbehandlung z. B. durch eine Legierungsschicht 17 miteinander verbunden.

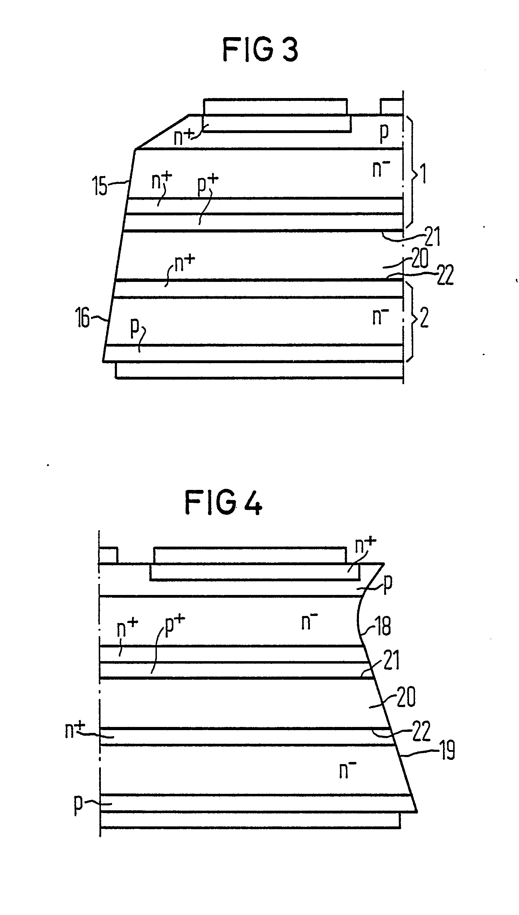

Die Ausführungsbeispiele nach den Fig. 3 und 4 unterscheiden sich von denen nach Fig. 1 bzw. Fig. 2 dadurch, daß die Halbleiterkörper 1 und 2 statt durch eine Legierungsschicht durch eine Ronde 20 und beidseitigen Legierungsschichten 21 und 22 miteinander verbunden sind. Die Ronde 20 besteht z. B. aus einem Metall mit einem thermischen Ausdehnungskoeffizienten, der dem des Halbleitermaterials benachbart ist, beispielsweise aus Molybdän. Sie kann jedoch auch aus stark p-oder n-dotiertem Silicium bestehen. Die Scheiben nach den Ausführungsbeispielen in Fig. 2 und 4 haben ihren geringsten Durchmesser d in der Mittelzone 5. Der geringste Durchmesser kann jedoch auch in der Nähe des Anodenkontakts bzw. der Anodenzone 7 des Halbleiterkörpers 1 liegen. Für das Ausführungsbeispiel nach Fig. 4 kann der kleinste Durchmesser d auch im Bereich der Ronde 20 liegen.

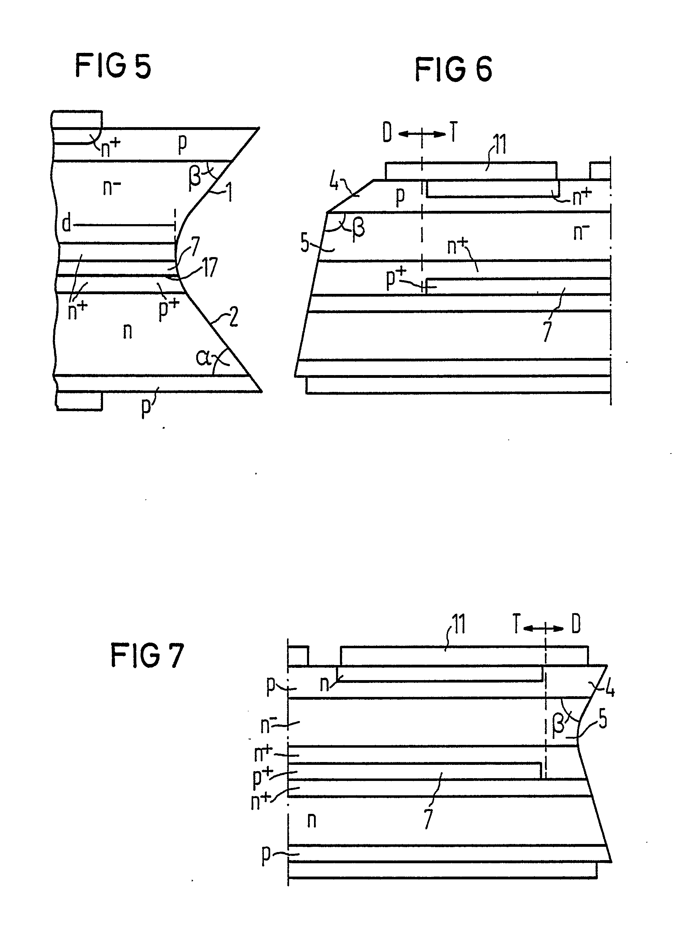

Für Anwendungen, bei denen eine geringe Freiwerdezeit benötigt wird, ist es vorteilhaft, dem asymmetrisch sperrenden Thyristor eine Diode antiparallel zu schalten. Diese führt die Speicherladung der Seriendiode ab. Damit wird der Thyristor rückwärts leitend. Die Diode kann, wie in den Fig. 6 und 7 dargestellt im Randbereich des asymmetrisch sperrenden Thyristors liegen. Die Grenze zwischen beiden Bauelementen ist in den Figuren durch eine gestrichelte Linie angedeutet. Außerhalb dieser Linie zum Rand hin liegt die Diode D, innerhalb der Thyristor T. Im Ausführungsbeispiel nach Fig. 6 liegt zwischen dem Sperrspannung aufnehmenden pn-Übergang zwischen den Zonen 4 und 5 der Diode D wieder ein negativer Winkel β, dessen an sich ungünstiger Einfluß wie in Verbindung mit Fig. 1 beschrieben durch eine starke Abflachung der Randfläche der Zone 4 kompensiert wird. Im Ausführungsbeispiel nach Fig. 7 grenzt der Sperrspannung aufnehmende pn-Übergang unter einem positiven Winkel β an den Rand an.

## Ansprüche

1. Halbleiterbauelement mit einem asymmetrisch sperrenden Thyristor und einer dem Thyristor in Reihe geschalteten Diode, deren Halbleiterkörper (2) elektrisch und mechanisch mit dem Anodenkontakt des Halbleiterkörpers (1) des Thyristors verbunden ist, so daß eine einzige Scheibe gebildet wird, und mit einer Abschrägung der Randflächen (15, 16, 18, 19) jedes Halbleiterkörpers, **dadurch gekennzeichnet,** daß die Randflächen (15, 16; 18, 19) beider Halbleiterkörper (1, 2) kontinuierlich ineinander übergehen.

2. Halbleiterbauelement nach Anspruch 1, **dadurch gekennzeichnet,** daß die Randfläche der katodenseitigen Basiszone (4) des Thyristors unter einem negativen Winkel abgeschrägt ist und daß die Anodenzone (10) der Diode (2) unter einem positiven Winkel abgeschrägt ist.

3. Halbleiterbauelement nach Anspruch 1, **dadurch gekennzeichnet,** daß die Randfläche der katodenseitigen Basiszone (4) des Thyristors und die Randfläche der Anodenzone (10) der Diode unter einem positiven Winkel abgeschrägt sind.

4. Halbleiterbauelement nach Anspruch 3, **dadurch gekennzeichnet,** daß die Scheibe (1 + 2) wenigstens annähernd an der Mittelzone (5) des Halbleiterkörpers des Thyristors ihren kleinsten Durchmesser (d) hat.

5. Halbleiterbauelement nach Anspruch 3, **dadurch gekennzeichnet,** daß die Scheibe ihren kleinsten Durchmesser (d) wenigstens annähernd an der Anodenzone (6, 7) des Halbleiterkörpers des Thyristors hat.

6. Halbleiterbauelement nach einem der Ansprüche 1 bis 5, **dadurch gekennzeichnet,** daß beide Halbleiterkörper (1, 2) zusammenlegiert sind.

7. Halbleiterbauelement nach einem der Ansprüche 1 bis 5, **dadurch gekennzeichnet,** daß zwischen beiden Halbleiterkörpern eine Ronde (20) aus einem metallähnlichen thermischen Ausdehnungskoeffizienten wie das Material der Halbleiterkörper angeordnet ist und daß der Rand der Ronde (20) abgeschrägt ist.

8. Halbleiterbauelement nach einem der Ansprüche 1 bis 5, **dadurch gekennzeichnet,** daß zwischen beiden Halbleiterkörpern eine Ronde (20) aus stark dotiertem Halbleitermaterial angeordnet ist und daß der Rand der Ronde abgeschrägt ist.

9. Halbleiterbauelement nach einem der Ansprüche 1 bis 8, **dadurch gekennzeichnet,** daß an der Randfläche (15, 18) des Halbleiterkörpers des asymmetrisch sperrenden Thyristors (1) eine diesem Halbleiterkörper (1) antiparallel geschaltete Diode (D) integriert ist und daß der Rand der Anodenzone (4) der antiparallelen Diode abgeschrägt ist.

# FIG 1

# FIG 2

# FIG 3

# FIG 4

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| D,Y | EP-A-0 167 929  (SIEMENS)<br>* Zusammenfassung; Figur 4 *<br><br>--- | 1 | H 01 L  29/743<br>H 01 L  29/06 |
| Y | EP-A-0 075 945  (TOKYO SHIBAURA DENKI K.K.)<br>* Zusammenfassung; Figur 3 *<br><br>--- | 1 | |
| A | IEEE TRANSACTIONS ON ELECTRON DEVICES, Band ED-31, Nr. 6, Juni 1984, Seiten 733-738, IEEE, New York, US; K.-P. BRIEGER et al.: "The influence of surface charge and bevel angle on the blocking behavior of a high-voltage p+-n-n+ device"<br><br>----- | | |

**RECHERCHIERTE SACHGEBIETE (Int. Cl.4)**

H 01 L  29

Der vorliegende Recherchenbericht wurde für alle Patentansprüche erstellt.

| Recherchenort | Abschlußdatum der Recherche | Prüfer |
|---|---|---|
| DEN HAAG | 20-08-1987 | PELSERS L. |